(19) Europäisches Patentamt
European Patent Office
Office européen des brevets

(11) **EP 2 157 146 A1**

(12) **EUROPEAN PATENT APPLICATION**
published in accordance with Art. 153(4) EPC

(43) Date of publication:
**24.02.2010 Bulletin 2010/08**

(51) Int Cl.:
**C09J 7/02** (2006.01)       **H01R 11/01** (2006.01)

(21) Application number: **07745185.4**

(22) Date of filing: **13.06.2007**

(86) International application number:
**PCT/JP2007/061918**

(87) International publication number:
**WO 2008/152711 (18.12.2008 Gazette 2008/51)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Hitachi Chemical Company, Ltd. Tokyo 163-0449 (JP)**

(72) Inventors:
• **KOJIMA, Kazuyoshi**
  **Chikusei-shi**
  **Ibaraki 308-8524 (JP)**

• **KOBAYASHI, Kouji**
  **Chikusei-shi**
  **Ibaraki 308-8524 (JP)**
• **ARIFUKU, Motohiro**
  **Chikusei-shi**
  **Ibaraki 308-8524 (JP)**

(74) Representative: **Jönsson, Hans-Peter**
  **Patentanwälte von Kreisler Selting Werner**
  **Deichmannhaus am Dom**
  **Bahnhofsvorplatz 1**
  **50667 Köln (DE)**

(54) **FILMY ADHESIVE FOR CIRCUIT CONNECTION**

(57)    A film-like adhesive for circuit connection which is situated between mutually opposing circuit electrodes and, upon heating and pressing the mutually opposing circuit electrodes, electrically connects the electrodes in the pressing direction, **characterized in that** the water contact angle of the adhesive after curing is 90° or greater.

# Fig.2

## Description

### Technical Field

The present invention relates to a film-like adhesive for circuit connection, and specifically it relates to a film-like adhesive for circuit connection that can be used for electrical connection mainly between liquid crystal panel electrodes and FPC (flexible printed circuit board) electrodes, between FPC electrodes and PCB (printed circuit board) electrodes, and between IC chip or other electronic part electrodes and liquid crystal panel electrodes or PCB electrodes.

### Background Art

Film-like adhesives for circuit connection having conductive particles dispersed in insulating adhesive resins are used for electrical connection between liquid crystal panel electrodes and FPC electrodes, between FPC electrodes and PCB electrodes, and between IC chip or other electronic part electrodes and liquid crystal panel electrodes or PCB electrodes. Specifically, a film-like adhesive for circuit connection is situated between mutually opposing circuit electrodes, and the mutually opposing circuit electrodes are heated and pressed to establish electrical connection between the electrodes in the pressing direction. An example of a known film-like adhesive for circuit connection is the epoxy resin-based film-like adhesive for circuit connection disclosed in Japanese Unexamined Patent Publication HEI No. 3-16147 (see Patent document 1).

However, when a connected structure connected with a conventional film-like adhesive for circuit connection is electrified in a high-humidity environment, a type of electrodeposition known as migration occurs on the electrical circuit or electrode, thus impairing the connection reliability. The migration is believed to occur due to ionization of the impurities in the adhesive or metals composing the electrode, during voltage application.

Methods for reducing ion concentrations in adhesives have been investigated, and for example, techniques are known for adding ion scavengers such as antimony/bismuth-based oxides or magnesium/aluminum-based oxides to film-like adhesives for circuit connection (see Patent document 2, for example).

[Patent document 1] Japanese Unexamined Patent Publication HEI No. 3-16147

[Patent document 2] Japanese Unexamined Patent Publication HEI No. 9-199207

### Disclosure of the Invention

### Problems to be Solved by the Invention

The technique described in Patent document 2, however, is associated with certain problems mentioned below and has not always been satisfactory from the viewpoint of circuit connection reliability. Specifically, the technology is problematic because when the particle size of the ion scavenger is greater than the conductive particle size it becomes impossible to obtain satisfactory electrical connection through the conductive particles, and when the particle size of the ion scavenger is smaller than the conductive particle size the electrical connection is impeded by infiltration of the scavenger between the conductive particles and electrodes. In the prior art mentioned above, therefore, it is difficult to adequately improve migration resistance while ensuring connection reliability between mutually opposing circuit electrodes.

The present invention has been accomplished in light of the aforementioned problems of the prior art, and its object is to provide a film-like adhesive for circuit connection which has excellent migration resistance and can improve circuit connection reliability in high-humidity environments.

### Means for Solving the Problems

As a result of much diligent research aimed at achieving the object stated above, the present inventors have found that a circuit connection structure, in which connection is made by a film-like adhesive exhibiting a post-curing water contact angle above a specific value, has sufficiently low migration in an established humidity resistance energizing test, and the invention has been completed upon this finding.

Specifically, the invention provides a film-like adhesive for circuit connection which is situated between mutually opposing circuit electrodes and, upon heating and pressing the mutually opposing circuit electrodes, electrically connects the electrodes in the pressing direction, the film-like adhesive for circuit connection being **characterized in that** the water contact angle after curing of the adhesive is 90° or greater.

Here, "after curing of the adhesive" means that the curing rate C is at least 80%, as defined by the following formula (1) where Q0 (J/g) is the heat value of the adhesive before curing as measured using a DSC (differential scanning calorimeter) and Q1 (J/g) is the heat value of the adhesive after curing as measured using a DSC (differential scanning calorimeter).

$$C\ (\%) = (Q0\text{-}Q1)/Q0 \times 100 \quad (1)$$

Also, "water contact angle" means the value measured according to JIS R3257, under conditions with a temperature of $25\pm5°C$ and a humidity of $50\pm10\%$.

The film-like adhesive for circuit connection according to the invention can adequately inhibit migration even when the connected circuit connection structure is energized in a high-humidity environment, thus improving the circuit connection reliability in high-humidity environments.

Incidentally, it is expected that spaces between circuit electrodes will be even further reduced as micronization of circuit patterns continues to increase, and since the film-like adhesive for circuit connection of the invention has excellent migration resistance, it can effectively prevent shorting caused by migration even when circuit electrodes with such fine patterns are connected.

The film-like adhesive for circuit connection of the invention preferably comprises a phenoxy resin, epoxy resin, rubber component and latent curing agent. This will further improve the migration resistance of the adhesive, to allow an even higher level of circuit connection reliability to be achieved.

While the reason for these effects exhibited by an adhesive comprising such components are not thoroughly understood, the present inventors conjecture as follows. That is, it is believed that an adhesive comprising a phenoxy resin, epoxy resin, rubber component and latent curing agent, and having a water contact angle of at least 90° after curing, creates a satisfactory balance between high levels of effects such as improved heat resistance of the adhesive due to the phenoxy resin, improved cohesion and moisture proofness for the connected structure due to the rubber component, and accelerated curing of the latent curing agent due to the epoxy resin. As a result, the present inventors conjecture, penetration of moisture into the circuit electrode is greatly inhibited, thus producing the effect described above. Moreover, the combination of the epoxy resin and latent curing agent contributes to both storage stability and curability of the adhesive, so that handleability and workability are both improved while obtaining the effect described above.

The phenoxy resin is preferably one containing a fluorene ring, from the viewpoint of further increasing the migration resistance.

The reason for increased migration resistance when using a phenoxy resin with a fluorene ring is conjectured by the present inventors to be as follows. Specifically, it is believed that introducing a fluorene ring into the phenoxy resin in the combination of the phenoxy resin, epoxy resin, rubber component and latent curing agent improves the heat resistance of the adhesive and avoids looseness of the circuit joints even in high-temperature conditions, thus more satisfactorily preventing penetration of moisture and increasing the migration resistance.

The epoxy resin is preferably one with a naphthalene backbone, from the viewpoint of further increasing the migration resistance. The reason for increased migration resistance when using an epoxy resin with a naphthalene backbone is conjectured to be as follows by the present inventors. Specifically, it is believed that introducing a naphthalene backbone into the epoxy resin in the combination of the phenoxy resin, epoxy resin, rubber component and latent curing agent promotes curing of the latent curing agent and results in firm curing of the adhesive, thus allowing penetration of moisture to be adequately prevented and further increasing the migration resistance.

The molecular weight of the rubber component is preferably 700,000 or greater. This can further increase the cohesion and moisture proofness of the adhesive, to more reliably obtain excellent migration resistance.

The invention further provides a film-like adhesive for circuit connection which is situated between mutually opposing circuit electrodes and, upon heating and pressing the mutually opposing circuit electrodes, electrically connects the electrodes in the pressing direction, the film-like adhesive for circuit connection being characterized by comprising a phenoxy resin having an aromatic cyclic structure containing two or more benzene rings, an epoxy resin, a rubber component and a latent curing agent.

The film-like adhesive for circuit connection described above can adequately inhibit migration even when the connected circuit connection structure is energized in a high-humidity environment, thus improving the circuit connection reliability in high-humidity environments. Furthermore, since the film-like adhesive for circuit connection of the invention has excellent migration resistance, it can effectively prevent shorting caused by migration even when circuit electrodes with such fine patterns are connected.

The aromatic cyclic structure with two or more benzene rings in the film-like adhesive for circuit connection is preferably derived from a polycyclic aromatic compound.

The polycyclic aromatic compound is preferably a dihydroxy compound.

The dihydroxy compound is preferably a compound having a naphthalene, acenaphthene, fluorene, dibenzofuran, anthracene or phenanthrene structure.

In the film-like adhesive for circuit connection described above, the polycyclic aromatic compound is preferably a dihydroxy compound with a fluorene ring structure.

The polycyclic aromatic compound is also preferably a diphenol compound with a fluorene ring structure.

**Effect of the Invention**

According to the invention it is possible to provide a film-like adhesive for circuit connection, which has excellent migration resistance and can improve circuit connection reliability in high-humidity environments.

**Brief Description of the Drawings**

Fig. 1 is a simplified cross-sectional view showing an embodiment of a film-like adhesive for circuit connection according to the invention.

Fig. 2 is a simplified cross-sectional view showing an embodiment of a circuit member connection structure connected by a flm-like adhesive for circuit connection according to the invention.

Fig. 3(a)-(c) are a series of process steps for connection of circuit members.

**Explanation of Symbols**

1,40: Film-like adhesives for circuit connection, 5: adhesive composition, 7: conductive particles, 11: insulating material, 20,30: circuit members, 21,31: circuit boards, 22, 32: circuit electrodes.

**Best Mode for Carrying Out the Invention**

Preferred embodiments of the invention will now be explained in detail, with reference to the accompanying drawings as necessary. Identical or corresponding parts in the drawings will be referred to by like reference numerals and will be explained only once.

The first film-like adhesive for circuit connection according to the invention is a film-like adhesive for circuit connection which is situated between mutually opposing circuit electrodes and, upon heating and pressing the mutually opposing circuit electrodes, electrically connects the electrodes in the pressing direction, and it is **characterized in that** the water contact angle of the adhesive after curing is 90°C or greater.

The film-like adhesive for circuit connection of the invention preferably comprises a phenoxy resin, epoxy resin, rubber component and latent curing agent.

As examples of phenoxy resins to be used for this embodiment, there may be mentioned resins obtained either by reacting a bifunctional phenol with an epihalohydrin to a high molecular weight, or by polyaddition of a bifunctional epoxy resin and a bifunctional phenol. More specifically, the phenoxy resin may be obtained by, for example, reacting a bifunctional phenol with an epihalohydrin in a non-reactive solvent at a temperature of 40-120°C, in the presence of a catalyst such as an alkali metal hydroxide. The phenoxy resin may be obtained by polyaddition reaction of a bifunctional epoxy resin and a bifunctional phenol, with heating to 50-200°C under conditions with a reaction solid content of no greater than 50 parts by weight, in an amide-based, ether-based, ketone-based, lactone-based or alcohol-based organic solvent with a boiling point of 120°C or higher, in the presence of a catalyst such as an alkali metal compound, organic phosphorus-based compound, cyclic amine-based compound or the like. A phenoxy resin may be used alone, or two or more different ones may be used in combination.

As bifunctional epoxy resins there may be mentioned bisphenol A-type epoxy resin, bisphenol F-type epoxy resin, bisphenol AD-type epoxy resin and bisphenol S-type epoxy resin.

Bifunctional phenols have two phenolic hydroxyl groups, and examples of such bifunctional phenols include bisphenols such as bisphenol A, bisphenol F, bisphenol AD and bisphenol S.

The phenoxy resin preferably includes an aromatic cyclic structure with two or more benzene rings in the molecule. As aromatic cyclic structures with two or more benzene rings there may be mentioned molecular structures of polycyclic aromatic compounds. As examples of polycyclic aromatic compounds there may be mentioned dihydroxy compounds having naphthalene, acenaphthene, fluorene, dibenzofuran, anthracene or phenanthrene structures. Preferred among these polycyclic aromatic compounds are dihydroxy compounds with fluorene ring structures. The polycyclic aromatic compound is preferably a diphenol compound with a fluorene ring structure, and it is most preferably 4,4'-(9-fluorenylidene)-diphenol.

A phenoxy resin which is used may be one obtained by polyaddition of a bifunctional epoxy resin and a dihydroxy compound with a biphenyl backbone.

The content of the phenoxy resin in the adhesive is preferably 10-40 wt% and more preferably 10-30 wt% with respect to the total amount of adhesive. A phenoxy resin content of less than 10 wt% will interfere with the effect of increasing the migration resistance, while a content of greater than 40 wt% will reduce the flow property of the adhesive and impede conduction between the electrodes.

As examples of epoxy resins to be used for this embodiment there may be mentioned bisphenol-type epoxy resins derived from epichlorohydrin and bisphenol A, F or AD, silicon-modified epoxy resins, and naphthalene-type epoxy resins having a naphthalene ring on the main backbone. Naphthalene-type epoxy resins are preferred among these. The aforementioned epoxy resins may be used alone or in combinations of two or more. These epoxy resins are preferably high purity products with the impurity ion ($Na^+$, $Cl^-$, etc.) and hydrolyzable chlorine content reduced to below 300 ppm, in order to inhibit migration.

The content of the epoxy resin in the adhesive is preferably 10-50 wt% and more preferably 20-40 wt% with respect to the total amount of adhesive. An epoxy resin content of less than 10 wt% will result in incomplete curing of the adhesive due to the low amount of epoxy resin component reacting with the latent curing agent, thus leading to greater penetration of moisture. The flow property of the adhesive will also be reduced, thus interfering with conduction between the electrodes, since the mixing proportion of the other constituent materials of the adhesive (phenoxy resin and rubber component) will be increased. On the other hand, a content of greater than 50 wt% will result in an excessively high flow property of the adhesive, tending to produce numerous air bubbles in the joints after contact bonding, and promoting penetration of water under high-humidity conditions.

As examples of rubber components to be used for this embodiment there may be mentioned polymers and copolymers of one or more monomer components from among acrylic acid, acrylic acid esters, methacrylic acid esters and acrylonitrile. Copolymer-based acrylic rubber containing glycidyl acrylate or glycidyl methacrylate with a glycidyl ether group, is preferred for excellent stress relaxation.

The molecular weight of the rubber component is preferably at least 700,000 as the weight-average molecular weight (Mw), from the viewpoint of increasing the cohesion and moisture proofness of the adhesive.

The content of the rubber component in the adhesive is preferably 10-50 wt% and more preferably 20-40 wt% with respect to the total amount of adhesive. If the rubber component content is less than 10 wt% it will be difficult to guarantee cohesion of the adhesive, and water will more readily penetrate into the joints under high-humidity conditions. If the content is greater than 50 wt%, on the other hand, the flow property of the adhesive will be reduced and conduction may not be established between the electrodes.

As examples of latent curing agents to be used for this embodiment there may be mentioned imidazole-based, hydrazine-based, amineimide and dicyaninediimide agents. These may be used alone or in combinations of two or more. From the viewpoint of extending the pot life of the adhesive, these curing agents are preferably used in a microencapsulated form by coating with a polyurethane-based or polyester-based macromolecular substance.

From the viewpoint of obtaining a sufficient reaction rate, the content of the latent curing agent in the adhesive is preferably 0.1-50 wt% and more preferably 1-30 wt% with respect to the total amount of adhesive. If the latent curing agent content is less than 0.1 wt% the curing of the adhesive will tend to be insufficient, and if it is greater than 50 wt% the flow property will be reduced, making it difficult to establish conduction between the electrodes and tending to shorten the pot life of the adhesive.

The film-like adhesive for circuit connection of this embodiment preferably contains conductive particles. Although connection between the circuit members can be established by direct contact between the circuit electrodes without including conductive particles, addition of conductive particles can actively impart anisotropic conductivity and can absorb chip bumps or variations in the board electrodes, thus allowing more stable connection to be achieved.

As examples of conductive particles there may be mentioned particles of metals such as Ni, Au, Ag, Cu or solder, and spherical polymer nuclei such as polystyrene with conductive layers of Ni or Au formed thereon. Conductive particles covered on the surfaces with an insulating resin may also be used.

According to this embodiment, the conductive particles preferably have nuclei that are particles formed of a transition metal such as Ni or non-conductive glass, ceramic, plastic or the like, having the surfaces covered with a covering layer made of a precious metal such as Au. Conductive particles having such a precious metal covering layer undergo deformation when the circuit-connecting material is heated and pressed, thus increasing the contact area with the circuit electrodes and further improving reliability.

The particle sizes of the conductive particles must be smaller than the minimum distance between the electrodes of the board to be connected, and when the electrodes have large height variation, they are preferably larger than the height variation. Specifically, the particle sizes of the conductive particles are preferably 1-10 $\mu$m.

The content of the conductive particles dispersed in the adhesive is preferably 0.1-30 vol% and more preferably 0.1-15 vol% based on the total volume of the adhesive. If the conductive particle content is greater than 30 vol%, shorting will tend to occur more easily between adjacent electrodes.

The film-like adhesive for circuit connection of this embodiment may contain a coupling agent in an amount that does not interfere with the migration resistance. Preferred examples of coupling agents, from the viewpoint of cohesion, are compounds containing one or more groups selected from among ketimine, vinyl, acrylic, amino, epoxy and isocyanate groups.

The film-like adhesive for circuit connection of this embodiment can be produced by preparing an adhesive composition for circuit connection comprising the phenoxy resin, epoxy resin, rubber component, latent curing agent and conductive particles as well as other components as necessary, and forming the composition into a film.

The film formation may be carried out by dissolving or dispersing the adhesive composition for circuit connection in an organic solvent to prepare a liquid coating solution, coating the coating solution onto a releasable film, and removing the solvent at below the active temperature of the curing agent. From the viewpoint of increasing the solubility of the adhesive composition, the organic solvent used is preferably a mixed solvent comprising an aromatic hydrocarbon-based and oxygen-containing solvent (toluene, ethyl acetate or the like) for solubility of the material.

The following method may be used to confirm whether or not the film-like adhesive for circuit connection of this embodiment has a water contact angle of 90° or greater after curing.

(1) First, the film-like adhesive for circuit connection is attached onto slide glass. It may be pressed while heating during this time, provided that the heating temperature does not cause curing of the adhesive composition in the film-like adhesive for circuit connection. Next, the film-like adhesive for circuit connection is cured under prescribed heating conditions so that the curing rate C is at least 80%, as defined by the following formula (1).

$$C\,(\%) = (Q0\text{-}Q1)/Q0 \times 100 \quad (1)$$

In formula (1), Q0 represents the heat value (J/g) of the adhesive before curing and Q1 represents the heat value (J/g) of the adhesive after curing under the prescribed heating conditions, as measured using a DSC (differential scanning calorimeter).

(2) Next, the water contact angle on the obtained cured surface is measured according to JIS R3275, under conditions with a temperature of $25\pm5°C$ and a humidity of $50\pm10\%$. Purified water is used for the water dropped onto the cured surface for measurement. The measurement may be carried out using a contact angle meter such as "CA-W150" (Kyowa Interface Science Co., Ltd.), for example.

For this embodiment, the types and contents or the phenoxy resin, epoxy resin, rubber component and latent curing agent may be appropriately selected so that the contact angle as measured above is at least 90°, to obtain a film-like adhesive for circuit connection according to the invention.

As examples of methods for increasing the contact angle after curing for the film-like adhesive for circuit connection of this embodiment, there may be mentioned a method in which a phenoxy resin having an aromatic cyclic structure with two or more benzene rings (especially a fluorene ring) in the molecule is used and the phenoxy resin content is increased, or a method in which the rubber component content is increased. As methods for decreasing the contact angle after curing there may be mentioned a method of decreasing the phenoxy resin content, and a method of decreasing the rubber component content. A silicon-modified epoxy resin may also be added to increase the contact angle after curing.

From the viewpoint of obtaining satisfactory properties as a circuit connection adhesive while improving the migration resistance, the film-like adhesive for circuit connection of this embodiment has a contact angle of preferably 90°-110°, more preferably 90°-100° and even more preferably 95°-98°, as measured in the manner described above.

From the viewpoint of obtaining satisfactory properties as a circuit connection adhesive while improving the migration resistance, the contact angle measured as described above is preferably 92° or greater, more preferably 95° or greater and even more preferably 97° or greater.

The film-like adhesive for circuit connection of this embodiment also preferably has a curing rate C of at least 80% as defined by (1) above, when curing is carried out for 1 hour in a clean oven heated to 190°C.

The second film-like adhesive for circuit connection of the invention is a film-like adhesive for circuit connection which is situated between mutually opposing circuit electrodes and, upon heating and pressing the mutually opposing circuit electrodes, electrically connects the electrodes in the pressing direction, characterized by comprising a phenoxy resin having an aromatic cyclic structure containing two or more benzene rings, an epoxy resin, a rubber component and a latent curing agent.

The phenoxy resin having an aromatic cyclic structure containing two or more benzene rings, the epoxy resin, the rubber component and the latent curing agent may be suitably selected among the examples mentioned for the first film-like adhesive for circuit connection of the invention.

The aromatic cyclic structure with two or more benzene rings in the film-like adhesive for circuit connection of this embodiment is preferably derived from a polycyclic aromatic compound. That is, the phenoxy resin is preferably one synthesized by the method described above using a polycyclic aromatic compound having an aromatic cyclic structure with two or more benzene rings as the constituent material.

The polycyclic aromatic compound is preferably a dihydroxy compound. The dihydroxy compound is preferably a compound having a naphthalene, acenaphthene, fluorene, dibenzofuran, anthracene or phenanthrene structure.

For this embodiment, the polycyclic aromatic compound is preferably a dihydroxy compound with a fluorene ring structure, and more preferably it is a diphenol compound with a fluorene ring structure. A particularly preferred polycyclic aromatic compound is 4,4'-(9-fluorenylidene)-diphenol.

The contents of the phenoxy resin, epoxy resin, rubber component and latent curing agent in the second film-like adhesive for circuit connection of the invention are preferably set within the same ranges as for the first film-like adhesive for circuit connection of the invention.

From the viewpoint of obtaining satisfactory properties as a circuit connection adhesive while improving the migration resistance, the water contact angle of the second film-like adhesive for circuit connection of the invention after curing of the adhesive is preferably 90° or greater, more preferably 90°-110°, even more preferably 90°-100° and most preferably 95°-98°.

From the viewpoint of obtaining satisfactory properties as a circuit connection adhesive while improving the migration resistance, the contact angle measured as described above is preferably 92° or greater, more preferably 95° or greater and even more preferably 97° or greater.

The method of increasing the contact angle after curing for the second film-like adhesive for circuit connection of the invention may be, for example, a method in which the content of the phenoxy resin having an aromatic cyclic structure with two or more benzene rings (especially a fluorene ring) is increased, or a method in which the rubber component content is increased. As methods for decreasing the contact angle after curing there may be mentioned a method of decreasing the phenoxy resin content, and a method of decreasing the rubber component content. A silicon-modified epoxy resin may also be added to increase the contact angle after curing.

The second film-like adhesive for circuit connection of the invention preferably contains conductive particles. The conductive particles may be the same as described above.

The film-like adhesive for circuit connection of this embodiment can be produced by preparing an adhesive composition for circuit connection comprising the phenoxy resin, epoxy resin, rubber component, latent curing agent and conductive particles as well as other components as necessary, and forming the composition into a film.

The other components used may be the same as explained for the first film-like adhesive for circuit connection of the invention. The film formation may be carried out by the same method used for the first film-like adhesive for circuit connection of the invention.

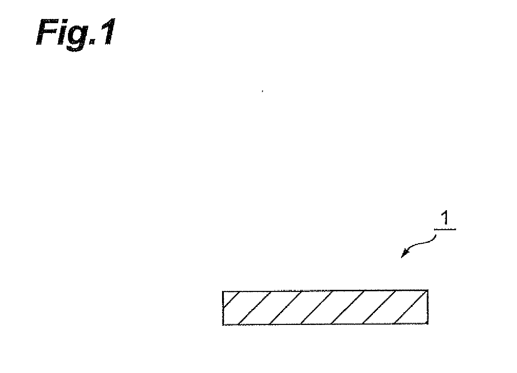

Fig. 1 is a cross-sectional view showing an embodiment of a film-like adhesive for circuit connection according to the invention. The film-like adhesive for circuit connection 1 shown in Fig. 1 is obtained by forming a film from the adhesive composition for circuit connection. The film-like adhesive for circuit connection is manageable and may be easily placed on adherends to facilitate connection.

The film-like adhesive for circuit connection 1 may have a multilayer construction with two or more layers. In such cases, the adhesive layer of the invention having a contact angle of 90° or greater after curing is situated on the adherend side, especially the circuit side, on which migration tends to occur. When the film-like adhesive for circuit connection of the invention is used as a constituent material of a multilayer ACF, the layer in contact with the adherend, on which migration tends to occur, is preferably made of the film-like adhesive for circuit connection of the invention. The layer can function as a migration-resistant layer after curing. For this embodiment, the contact angle of the migration-resistant layer can be measured to confirm that the contact angle after curing is 90° or greater.

The film-like adhesive for circuit connection 1 can be produced, for example, by using a coating apparatus to coat a support (PET (polyethylene terephthalate) film or the like) with the adhesive composition containing the phenoxy resin, epoxy resin, rubber component and latent curing agent, dissolved in the organic solvent, and drying with hot air for a prescribed time period at a temperature at which the adhesive composition does not cure. The thickness of the film-like adhesive for circuit connection 1 is not particularly restricted, but it is preferably thicker than the gap between the circuit members to be connected, and generally it is more preferably a film thickness which is at least 5 $\mu$m thicker than the gap, even more preferably a film thickness that is 7 $\mu$m-140 $\mu$m thicker than the gap, and most preferably a film thickness that is 10 $\mu$m-50 $\mu$m thicker than the gap.

Investigation by the present inventors has shown that migration tends to occur especially with electrodes formed on glass panels. Therefore, the film-like adhesive for circuit connection of the invention can be suitably used as a circuit connection adhesive for glass panels. In addition, the film-like adhesive for circuit connection of the invention allows a migration-resistant layer to be formed on glass panels. When the film-like adhesive for circuit connection of the invention is used as a constituent material of a multilayer ACF, a migration-resistant layer can be formed on a glass panel by situating the film-like adhesive for circuit connection of the invention on the side of the multilayer ACF in contact with the glass panel.

(Circuit member connection structure)

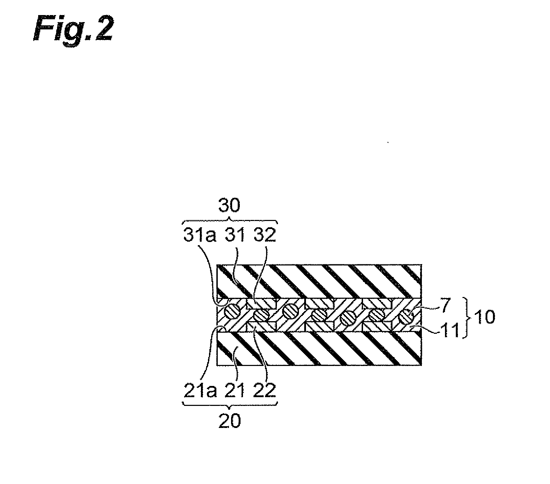

Fig. 2 is a simplified cross-sectional view showing an embodiment of a circuit member connection structure connected by a film-like adhesive for circuit connection according to the invention. As shown in Fig. 2, the circuit member connection structure of this embodiment comprises a first circuit member 20 and a second circuit member 30 which are mutually opposing, and a circuit-connecting member 10 which is formed between the first circuit member 20 and second circuit member 30 and electrically connects them.

The first circuit member 20 comprises a circuit board (first circuit board) 21, and circuit electrodes (first circuit electrodes) 22 formed on the main side 21a of the circuit board 21. An insulating layer (not shown) may also be formed on the main side 21a of the circuit board 21.

The second circuit member 30 comprises a circuit board (second circuit board) 31, and circuit electrodes (second circuit electrodes) 32 formed on the main side 31a of the circuit board 31. An insulating layer (not shown) may also be formed on the main side 31a of the circuit board 31.

The first and second circuit members 20, 30 are not particularly restricted so long as they contain the electrodes which require electrical connection. Specifically, there may be mentioned glass or plastic boards, printed circuit boards, ceramic circuit boards, flexible circuit boards, semiconductor silicon chips and the like on which electrodes are formed by ITO for use in liquid crystal display devices, and they may also be used in combination as necessary. According to this embodiment, therefore, it is possible to use printed circuit boards and circuit members with many and various surface forms including materials composed of organic materials such as polyimides, or inorganic materials which may be metals such as copper or aluminum, ITO (indium tin oxide), silicon nitride ($SiN_x$), silicon dioxide ($SiO_2$) or the like.

The circuit-connecting member 10 comprises an insulating material 11 and conductive particles 7. The conductive particles 7 are situated not only between each opposing first circuit electrode 22 and second circuit electrode 32, but also between the main sides 21a and 31a. In the circuit member connection structure, the circuit electrodes 22, 32 are electrically connected via the conductive particles 7. That is, the conductive particles 7 directly connect the circuit electrodes 22, 32.

The conductive particles 7 are not particularly restricted so long as they have a degree of conductivity permitting electrical connection, and they may be metal particles of Au, Ag, Ni, Cu, Co, solder or the like, or carbon. Also, non-conductive glass, ceramic, plastic or the like covered with a conductive material such as these metals may be used. The thickness of the metal layer to be covered in this case is preferably at least 10 nm in order to obtain sufficient conductivity.

In this circuit member connection structure, each facing circuit electrode 22 and circuit electrode 32 are electrically connected via the conductive particles 7, as mentioned above. Connection resistance between the circuit electrodes 22, 32 is therefore sufficiently reduced. Consequently, smooth current flow can be achieved between the first and second circuit electrodes 22, 32, to allow the function of the circuit to be adequately exhibited. When the circuit-connecting member 10 does not contain conductive particles 7, the circuit electrode 22 and circuit electrode 32 are electrically connected by being in direct contact.

As explained below, the circuit-connecting member 10 has adequate migration resistance even under high-humidity conditions since it is composed of the cured film-like adhesive for circuit connection according to the invention. Even with electrification in a high-humidity environment, therefore, electrodeposition on the circuit electrodes 22, 32 is adequately prevented, and the long-term reliability of the electrical characteristics between the circuit electrodes 22, 32 can be satisfactorily increased.

(Process for producing circuit member connection structure)

A process for producing the circuit member connection structure described above will now be explained.

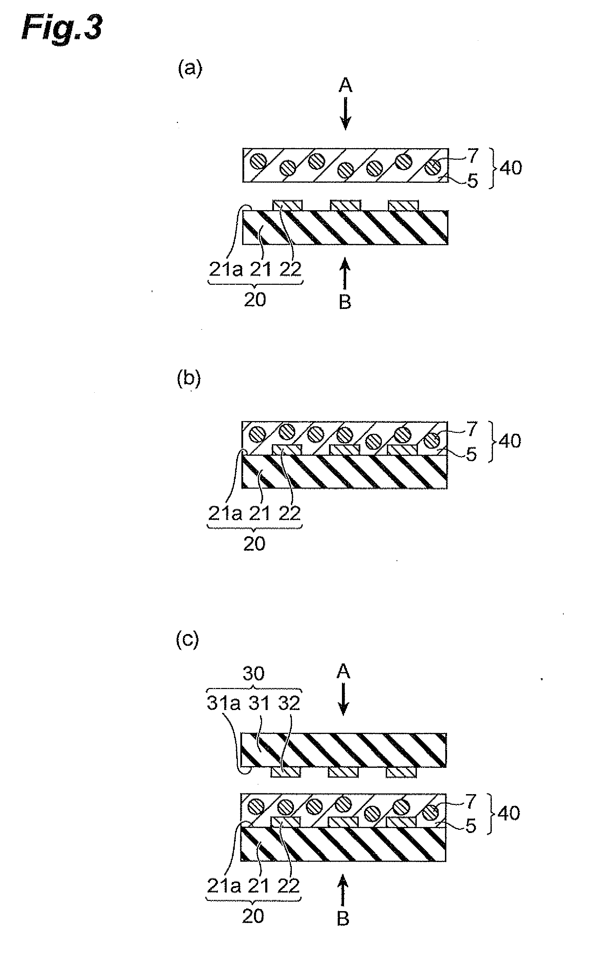

First, the first circuit member 20 and film-like adhesive for circuit connection 40 are prepared (see Fig. 3(a)). The film-like adhesive for circuit connection 40 is obtained by forming the circuit-connecting material into a film. The circuit-connecting material comprises an adhesive composition 5 and conductive particles 7. The adhesive composition 5 used comprises the aforementioned phenoxy resin, epoxy resin, rubber component and latent curing agent. When the circuit-connecting material does not contain conductive particles 7, the circuit-connecting material may be used as an insulating adhesive for anisotropic conductive bonding, in which case it is sometimes referred to as NCP (Non-Conductive Paste). When the circuit-connecting material contains conductive particles 7, the circuit-connecting material is sometimes referred to as ACP (Anisotropic Conductive Paste). Thus, a circuit member connection structure can be obtained using the film-like adhesive for circuit connection of the invention which functions as a NCF (Non-Conductive Film), instead of the film-like adhesive for circuit connection 40 that functions as an ACF (Anisotropic Conductive Film).

The content of conductive particles 7 in the circuit-connecting material is preferably 0.1-30 vol% and more preferably 0.1-15 vol% with respect to the total circuit-connecting material. If the content is less than 0.1 vol% it will tend to be difficult to obtain satisfactory conduction. If it exceeds 30 vol%, on the other hand, shorting may occur between adjacent circuits.

The film-like adhesive for circuit connection 40 is then placed over the side of the first circuit member 20 on which the circuit electrodes 22 have been formed. When the film-like adhesive for circuit connection 40 is attached onto a support, the film-like adhesive for circuit connection 40 is situated on the first circuit member 20 so that it is facing the first circuit member 20. The film-like adhesive for circuit connection 40 is easy to manage since it is in the form of a film. Thus, the film-like adhesive for circuit connection 40 may be easily situated between the first circuit member 20 and second circuit member 30 in order to facilitate the operation of connecting the first circuit member 20 and second circuit member 30.

The film-like adhesive for circuit connection 40 is pressed in the direction of the arrows A and B in Fig. 3 (a), for temporary connection of the circuit-connecting material film 40 on the first circuit member 20 (see Fig. 3(b)). The pressing may be carried out with heating. However, the heating temperature is a temperature that does not cause curing of the adhesive composition in the film-like adhesive for circuit connection 40.

Next, as shown in Fig. 3(c), the second circuit member 30 is placed on the film-like adhesive for circuit connection 40 with the second circuit electrodes facing the first circuit member 20. When the film-like adhesive for circuit connection 40 is attached onto a support, the second circuit member 30 is placed on the film-like adhesive for circuit connection 40 after releasing the support.

The film-like adhesive for circuit connection 40 is then pressed via the first and second circuit members 20, 30 in the direction of the arrows A and B in Fig. 3(c), while heating. The heating temperature during this time is above the active temperature of the curing agent. The film-like adhesive for circuit connection 40 is subjected to curing treatment for the main connection to obtain a circuit member connection structure as shown in Fig. 2.

The heating temperature is, for example, 170-200°C, and the connecting time is, for example, 10 seconds-1 minute. The conditions for the procedure may be appropriately selected according to the purpose of use, the adhesive composition and the circuit member, and postcuring may also be performed if necessary.

Manufacturing a circuit member connection structure in the manner described above will allow contact to be established between the circuit electrodes 22, 32 facing the conductive particles 7 in the circuit member connection structure, and thereby adequately reduce connection resistance between the circuit electrodes 22, 32.

Heating of the film-like adhesive for circuit connection 40 hardens the adhesive composition 5 with a sufficiently small distance between the first circuit electrodes 22 and second circuit electrodes 32, thus forming an insulating material 11 and firmly connecting the first circuit member 20 and second circuit member 30 via the circuit-connecting member 10. The circuit-connecting member 10 in the obtained circuit member connection structure has adequate migration resistance even under high-humidity conditions since it is composed of the cured film-like adhesive for circuit connection according to the invention. Consequently, the obtained circuit member connection structure can adequately prevent electrodeposition on the circuit electrodes 22, 32 even with electrification in a high-humidity environment, so that excellent connection reliability is achieved between the circuit electrodes 22, 32.

**Examples**

The present invention will now be explained in greater detail based on examples and comparative examples, with the understanding that the invention is in no way limited to the examples.

(Mixing materials)

First, the following materials were prepared as mixing materials for the film-like adhesive for circuit connection.

[Phenoxy resin-1]

A phenoxy resin was synthesized from a bisphenol A-type epoxy resin and a phenol compound (4,4'-(9-fluorenylidene)-diphenol) having a fluorene ring structure in the molecule. The weight-average molecular weight of the obtained resin was 40,000 as the value based on standard polystyrene by GPC. The resin was dissolved in a mixed solvent of toluene (boiling point of 110.6°C, SP value = 8.90)/ethyl acetate (boiling point of 77.1°C, SP value = 9.10) in a weight ratio of 50/50, to obtain a resin solution with a solid content of 40 wt%. This was designated as "phenoxy resin-1 ".

[Phenoxy resin-2]

A bisphenol A-type phenoxy resin (phenol 4-4'-(1-methylethylidene) bispolymer) was synthesized from a bisphenol A-type epoxy resin and epichlorohydrin. The weight-average molecular weight of the obtained resin was 30,000 as the value based on standard polystyrene by GPC. The resin was dissolved in a mixed solvent with a weight ratio of toluene/ethyl acetate = 50/50 to obtain a resin solution with a solid content of 40 wt%. This was designated as "phenoxy resin-2".

[Epoxy resin-1]

A naphthalene-type epoxy resin (naphthalenediol-based epoxy resin, trade name: HP-4032 by Dainippon Ink and Chemicals, Inc., epoxy equivalents: 149) was prepared. This was designated as "epoxy resin-1".

[Epoxy resin-2]

A bisphenol A-type epoxy resin (trade name: EPIKOTE828 by Yuka-Shell Epoxy Co., Ltd., epoxy equivalents: 184) was prepared. This was designated as "epoxy resin-2".

[Curing agent-containing epoxy resin-1]

A liquid curing agent-containing epoxy resin (epoxy equivalents: 202) was prepared containing a microencapsulated latent curing agent (microencapsulated amine-based curing agent), a bisphenol F-type epoxy resin and a naphthalene-type epoxy resin in a weight ratio of 34:49:17. This was designated as "curing agent-containing epoxy resin-1".

[Curing agent-containing epoxy resin-2]

A liquid curing agent-containing epoxy resin (epoxy equivalents: 213) was prepared containing a microencapsulated latent curing agent (microencapsulated amine-based Curing agent) and a bisphenol F-type epoxy resin in a weight ratio of 35:65. This was designated as "curing agent-containing epoxy resin-2".

[Acrylic rubber]

Acrylic rubber (copolymer of 40 parts by weight butyl acrylate, 30 parts by weight ethyl acrylate, 30 parts by weight acrylonitrile and 3 parts by weight glycidyl methacrylate, weight-average molecular weight: 800,000) was prepared as a rubber component. The acrylic rubber was dissolved in a mixed solvent with a weight ratio of toluene/ethyl acetate = 50/50 to obtain a solution with a solid content of 15 wt%.

[Conductive particles]

A nickel layer with a thickness of 0.2 $\mu$m was formed on the surface of particles having polystyrene nuclei, and then a gold layer was formed on the outside of the nickel layer to a thickness of 0.04 $\mu$m to produce conductive particles with a mean particle size of 5 $\mu$m.

(Example 1)

After combining phenoxy resin-1, acrylic rubber and curing agent-containing epoxy resin-1 in a mixing proportion of 20:30:50 as the solid weight ratio, 5 parts by weight of conductive particles were mixed and dispersed in 100 parts by weight of the mixture to obtain an adhesive composition. The obtained adhesive composition was coated onto a separator (silicone-treated polyethylene terephthalate film, thickness: 50 $\mu$m) using a roll coater. This was then heat-dried at 70°C for a period of 3 minutes to form a film-like adhesive with a thickness of 25 $\mu$m, to obtain a film-like adhesive for circuit connection for Example 1.

(Example 2)

A film-like adhesive for circuit connection for Example 2 was obtained in the same manner as Example 1, except that the mixing proportion of the phenoxy resin-1, acrylic rubber and curing agent-containing epoxy resin-1 in Example 1 was changed to 20:40:40 as the solid weight ratio.

(Example 3)

A film-like adhesive for circuit connection for Example 3 was obtained in the same manner as Example 1, except that the mixing proportion of the phenoxy resin-1, acrylic rubber and curing agent-containing epoxy resin-1 in Example 1 was changed to 20:20:60 as the solid weight ratio.

(Example 4)

After combining phenoxy resin-1, acrylic rubber, epoxy resin-1 and curing agent-containing epoxy resin-2 in a mixing proportion of 20:30:5:45 as the solid weight ratio, 5 parts by weight of conductive particles were mixed and dispersed in 100 parts by weight of the mixture to obtain an adhesive composition. A film-like adhesive for circuit connection for Example 4 was obtained in the same manner as Example 1, except for using this adhesive composition instead of the adhesive composition of Example 1.

(Example 5)

After combining phenoxy resin-2, acrylic rubber and curing agent-containing epoxy resin-1 in a mixing proportion of 20:30:50 as the solid weight ratio, 5 parts by weight of conductive particles were mixed and dispersed in 100 parts by weight of the mixture to obtain an adhesive composition. A film-like adhesive for circuit connection for Example 5 was obtained in the same manner as Example 1, except for using this adhesive composition instead of the adhesive composition of Example 1.

(Example 6)

After combining phenoxy resin-1, acrylic rubber and curing agent-containing epoxy resin-2 in a mixing proportion of 20:30:50 as the solid weight ratio, 5 parts by weight of conductive particles were mixed and dispersed in 100 parts by weight of the mixture to obtain an adhesive composition. A film-like adhesive for circuit connection for Example 6 was obtained in the same manner as Example 1, except for using this adhesive composition instead of the adhesive composition of Example 1.

(Comparative Example 1)

After combining phenoxy resin-2, acrylic rubber and curing agent-containing epoxy resin-2 in a mixing proportion of 20:30:50 as the solid weight ratio, 5 parts by weight of conductive particles were mixed and dispersed in 100 parts by weight of the mixture to obtain an adhesive composition. A film-like adhesive for circuit connection for Comparative Example 1 was obtained in the same manner as Example 1, except for using this adhesive composition instead of the adhesive composition of Example 1.

(Comparative Example 2)

After combining phenoxy resin-1, epoxy resin-1 and curing agent-containing epoxy resin-1 in a mixing proportion of 30:20:50 as the solid weight ratio, 5 parts by weight of conductive particles were mixed and dispersed in 100 parts by weight of the mixture to obtain an adhesive composition. A film-like adhesive for circuit connection for Comparative Example 2 was obtained in the same manner as Example 1, except for using this adhesive composition instead of the adhesive composition of Example 1.

(Comparative Example 3)

After combining phenoxy resin-1, epoxy resin-1 and curing agent-containing epoxy resin-2 in a mixing proportion of 30:20:50 as the solid weight ratio, 5 parts by weight of conductive particles were mixed and dispersed in 100 parts by weight of the mixture to obtain an adhesive composition. A film-like adhesive for circuit connection for Comparative Example 3 was obtained in the same manner as Example 1, except for using this adhesive composition instead of the adhesive composition of Example 1.

(Comparative Example 4)

After combining phenoxy resin-1, epoxy resin-2 and curing agent-containing epoxy resin-1 in a mixing proportion of 30:20:50 as the solid weight ratio, 5 parts by weight of conductive particles were mixed and dispersed in 100 parts by weight of the mixture to obtain an adhesive composition. A film-like adhesive for circuit connection for Comparative Example 4 was obtained in the same manner as Example 1, except for using this adhesive composition instead of the adhesive composition of Example 1.

(Comparative Example 5)

After combining phenoxy resin-2, acrylic rubber and curing agent-containing epoxy resin-2 in a mixing proportion of 20:20:60 as the solid weight ratio, 5 parts by weight of conductive particles were mixed and dispersed in 100 parts by weight of the mixture to obtain an adhesive composition. A film-like adhesive for circuit connection for Comparative Example 5 was obtained in the same manner as Example 1, except for using this adhesive composition instead of the adhesive composition of Example 1.

The film-like adhesives for circuit connection of Examples 1-6 and Comparative Examples 1-5 obtained as described above were used for contact angle measurement and migration resistance testing as follows. The obtained results are shown in Tables 1 and 2.

<Measurement of water contact angle>

The film-like adhesive for circuit connection was transferred onto slide glass and a clean oven was used for heat curing under conditions of 190°C, 1 hour. The water contact angle of the cured film-like adhesive surface was measured using a contact angle meter (CA-W150 by Kyowa Interface Science Co., Ltd.) according to JIS R3275, under conditions with a temperature of $25\pm5$°C and a humidity of $50\pm10$%. The measurement was carried out at 3 locations on the cured surface, and the average value was recorded as the contact angle. When the curing rate C1 of the adhesive cured under the aforementioned heat curing conditions was calculated, as defined by the following formula (2), it was confirmed to be 80% or greater for all of the film-like adhesives for circuit connection of Examples 1-6 and Comparative Examples 1-5. The calculated curing rates are shown in Table 1 and Table 2.

$$C1(\%) = (Q2\text{-}Q3)/Q2 \times 100 \quad (2)$$

In formula (2), Q2 represents the heat value (J/g) of the adhesive before curing and Q3 represents the heat value (J/g) of the adhesive after curing under the aforementioned heating conditions (190°C, 1 hour), as measured using a DSC (differential scanning calorimeter).

<Migration resistance test>

First, the obtained film-like adhesive for circuit connection was used to connect an ITO comb pattern electrode (pitch: 100 $\mu$m, line: 85 $\mu$m, space: 15 $\mu$m)-attached glass panel and a 2-layer FPC (pitch: 100 $\mu$m, line: 50 $\mu$m, space: 50 $\mu$m, circuit height: 8 $\mu$m, base: polyimide, circuit: Cu/Sn plating) by the following procedure, to produce a circuit connection structure.

The film-like adhesive cut to a prescribed size (1.5 $\times$ 25 mm) was attached to the ITO comb patterned glass panel under conditions of 80°C, 10 Kgf/cm$^2$, 4 seconds, and then the separator was released and the two-layer FPC circuit and the circuit on the glass panel side were positioned. This was then heated and pressed from above the FPC under conditions of 180°C, 3 MPa, 15 seconds for main connection.

The obtained circuit connection structure was placed in a test chamber at 60°C, 90% RH and DC 20 V was applied to the opposing comb electrodes. After 96 hours in this condition, a metallurgical microscope was used to observe the state of migration at the film-like adhesive joints (the sections of contact between the ITO electrode on the glass panel side and the electrode on the FPC side, and the adhesive run-out sections), which was evaluated based on the following criteria.

A: Slight (or no) migration occurred.
B: Some migration occurred.
C: Moderate migration occurred.
D: Notable migration occurred.

[Table 1]

|  |  | Example 1 | Example 2 | Example 3 | Example 4 | Example 5 | Example 6 |
|---|---|---|---|---|---|---|---|
| Mixing materials (solid content) | Phenoxy resin-1 | 20 | 20 | 20 | 20 | - | 20 |
|  | Phenoxy resin-2 | - | - | - | - | 20 | - |
|  | Beryl rubber | 30 | 40 | 20 | 30 | 30 | 30 |
|  | Epoxy resin-1 | - | - | - | 5 | - | - |
|  | Curing agent-containing epoxy resin-1 | 50 | 40 | 60 | - | 50 | - |
|  | Curing agent-containing epoxy resin-2 | - | - | - | 45 | - | 50 |
|  | Conductive particles | 5 | 5 | 5 | 5 | 5 | 5 |
| Curing rate (%) |  | 98.1 | 96.6 | 99.2 | 96.5 | 97.9 | 96.2 |
| Average contact angle (°) |  | 95.9 | 97.2 | 94.9 | 93.4 | 90.3 | 92.7 |
| Migration resistance |  | A-B | A | B | B | B | B |

[Table 2]

|  |  | Comp. Ex. 1 | Comp. Ex. 2 | Comp. Ex. 3 | Comp. Ex. 4 | Comp. Ex. 5 |
|---|---|---|---|---|---|---|
| Mixing materials (solid content) | Phenoxy resin-1 | - | 30 | 30 | 30 | - |
|  | Phenoxy resin-2 | 20 | - | - | - | 20 |
|  | Acryl rubber | 30 | - | - | - | 20 |
|  | Epoxy resin-1 | - | 20 | 20 | - | - |
|  | Epoxy resin-2 | - | - | - | 20 | - |
|  | Curing agent-containing epoxy resin-1 | - | 50 | - | 50 | - |
|  | Curing agent-containing epoxy resin-2 | 50 | - | 50 | - | 60 |
|  | Conductive particles | 5 | 5 | 5 | 5 | 5 |
| Curing rate (%) |  | 96.4 | 97.5 | 96.8 | 98.4 | 98.5 |
| Average contact angle (°) |  | 89.3 | 88.1 | 87.2 | 88.2 | 88.5 |
| Migration resistance |  | C | D | D | D | C-D |

As shown in Tables 1 and 2, the film-like adhesives for circuit connection of Comparative Examples 1-5 which had water contact angles of less than 90° after curing exhibited moderate to notable migration in the connected circuit connection structures, while the film-like adhesives for circuit connection of Examples 1-6 which had water contact angles of 90° or greater after curing exhibited slight (or none) to some migration in the connected circuit connection structures, thus confirming adequately superior migration resistance. The film-like adhesive for circuit connection of Example 2 exhibited particularly excellent migration resistance, suggesting that including a large amount of acrylic rubber increased the water contact angle after curing and further improved the cohesion and moisture proofness.

The film-like adhesive for circuit connection according to the invention can adequately inhibit migration even when the connected circuit connection structure has been energized in a high-humidity environment, thus allowing the circuit connection reliability in high-humidity environments to be improved.

**Industrial Applicability**

According to the invention it is possible to provide a film-like adhesive for circuit connection which has excellent migration resistance and can improve circuit connection reliability in high-humidity environments.

**Claims**

1.  A film-like adhesive for circuit connection which is situated between mutually opposing circuit electrodes and, upon heating and pressing the mutually opposing circuit electrodes, electrically connects the electrodes in the pressing direction, the film-like adhesive for circuit connection being **characterized in that** the water contact angle of the adhesive after curing is 90° or greater.

2.  A film-like adhesive for circuit connection according to claim 1, **characterized by** comprising a phenoxy resin, epoxy resin, rubber component and latent curing agent.

3.  A film-like adhesive for circuit connection according to claim 2, **characterized in that** the phenoxy resin has a fluorene ring.

4.  A film-like adhesive for circuit connection according to claim 2 or 3, **characterized in that** the epoxy resin has a naphthalene backbone.

5.  A film-like adhesive for circuit connection according to any one of claims 2 to 4, **characterized in that** the molecular weight of the rubber component is 700,000 or greater.

6.  A film-like adhesive for circuit connection which is situated between mutually opposing circuit electrodes and, upon heating and pressing the mutually opposing circuit electrodes, electrically connects the electrodes in the pressing direction, the film-like adhesive for circuit connection being **characterized by** comprising a phenoxy resin having an aromatic cyclic structure containing two or more benzene rings, an epoxy resin, a rubber component and a latent curing agent.

7.  A film-like adhesive for circuit connection according to claim 6, **characterized in that** the aromatic cyclic structure with two or more benzene rings is derived from a polycyclic aromatic compound.

8.  A film-like adhesive for circuit connection according to claim 7, **characterized in that** the polycyclic aromatic compound is a dihydroxy compound.

9.  A film-like adhesive for circuit connection according to claim 8, **characterized in that** the dihydroxy compound is a compound with a structure selected from among naphthalene, acenaphthene, fluorene, dibenzofuran, anthracene and phenanthrene.

10. A film-like adhesive for circuit connection according to claim 7, **characterized in that** the polycyclic aromatic compound is a dihydroxy compound with a fluorene ring.

11. A film-like adhesive for circuit connection according to claim 7, **characterized in that** the polycyclic aromatic compound is a diphenol compound with a fluorene ring.

**Fig.1**

*Fig.2*

# Fig.3

(a)

(b)

(c)

## INTERNATIONAL SEARCH REPORT

| | International application No. |
|---|---|
| | PCT/JP2007/061918 |

A. CLASSIFICATION OF SUBJECT MATTER
*C09J7/02*(2006.01)i, *H01R11/01*(2006.01)i

According to International Patent Classification (IPC) or to both national classification and IPC

B. FIELDS SEARCHED

Minimum documentation searched (classification system followed by classification symbols)
C09J7/02, H01R11/01

Documentation searched other than minimum documentation to the extent that such documents are included in the fields searched
Jitsuyo Shinan Koho        1922-1996    Jitsuyo Shinan Toroku Koho   1996-2007
Kokai Jitsuyo Shinan Koho  1971-2007    Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-253231 A  (Hitachi Chemical Co., Ltd.),<br>10 September, 2003 (10.09.03),<br>Claims; Par. Nos. [0005] to [0009]<br>(Family: none) | 6-11<br>1-5 |
| Y | JP 2001-302998 A  (Hitachi Chemical Co., Ltd.),<br>31 October, 2001 (31.10.01),<br>Claims; Par. Nos. [0025], [0046] to [0047],<br>[0082] to [0087]<br>& WO 2001/060938 A      & AU 200132298 A<br>& KR 2002075426 A      & US 2003/0069331 A1<br>& CN 1400993 A | 1-5 |
| Y | JP 2003-257247 A  (Hitachi Chemical Co., Ltd.),<br>12 September, 2003 (12.09.03),<br>Claims; Par. Nos. [0038] to [0039]<br>(Family: none) | 1-5 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered  to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 August, 2007 (07.08.07) | 21 August, 2007 (21.08.07) |

| Name and mailing address of the ISA/<br>Japanese Patent Office | Authorized officer |
|---|---|
| Facsimile No. | Telephone No. |

Form PCT/ISA/210 (second sheet) (April 2005)

<table>
<tr><td colspan="2" align="center">**INTERNATIONAL SEARCH REPORT**</td><td>International application No.<br>PCT/JP2007/061918</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| A | JP 10-251610 A  (Hitachi Chemical Co., Ltd.),<br>22 September, 1998 (22.09.98),<br>Claims; Par. Nos. [0007], [0010]<br>(Family: none) | 1-11 |
| A | JP 2007-009176 A  (Asahi Kasei Electronics Kabushiki Kaisha),<br>18 January, 2007 (18.01.07),<br>Claims; Par. No. [0028]<br>(Family: none) | 1-11 |
| A | JP 2005-187637 A  (Sekisui Chemical Co., Ltd.),<br>14 July, 2005 (14.07.05),<br>Claims; Par. No. [0070]<br>(Family: none) | 1-11 |

Form PCT/ISA/210 (continuation of second sheet) (April 2005)

**REFERENCES CITED IN THE DESCRIPTION**

**Patent documents cited in the description**

- JP 3016147 A
- JP 9199207 A